(19) Europäisches Patentamt
European Patent Office
Office européen des brevets

(11) **EP 2 511 652 A1**

(12) **EUROPEAN PATENT APPLICATION**
published in accordance with Art. 153(4) EPC

(43) Date of publication:
**17.10.2012 Bulletin 2012/42**

(21) Application number: **10834669.3**

(22) Date of filing: **03.12.2010**

(51) Int Cl.:
**G01B 11/24** (2006.01)    **H01L 21/66** (2006.01)

(86) International application number:
**PCT/JP2010/071734**

(87) International publication number:
**WO 2011/068219 (09.06.2011 Gazette 2011/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **04.12.2009 JP 2009275973**

(71) Applicant: **Sharp Kabushiki Kaisha Osaka-shi, Osaka 545-8522 (JP)**

(72) Inventor: **INOSHIRI, Ryou Osaka 545-8522 (JP)**

(74) Representative: **Müller - Hoffmann & Partner Patentanwälte Innere Wiener Strasse 17 81667 München (DE)**

(54) **SHAPE MEASUREMENT DEVICE AND SHAPE MEASUREMENT METHOD**

(57)    A MOCVD device (shape measurement device) of the present invention measure including the shape of a measurement object with use of a mobile platform (rotating table) for moving a substrate, that is, the measurement object, velocity measuring means (21) utilizing the Doppler effect of a laser beam, measurement object detecting means (25), arithmetic processing means (24), and storing means. The arithmetic processing means (24) includes: measurement object velocity extracting means (24a) for extracting the velocity of a measurement object; velocity average calculating means (24b) for calculating a velocity mean value from velocity data; subtracting means (24c) for subtracting the velocity mean value from the velocity data; and adding means (24d) for integrating the velocity.

FIG. 3

EP 2 511 652 A1

**Description**

Technical Field

The present invention relates to a device, such as a MOCVD device, and a method both for measuring the shape of a measurement object such as a substrate in a state in which the measurement object is placed on a mobile platform that is rotated or planetarily rotated.

Background Art

Crystal growth for a compound semiconductor such as a semiconductor laser element and an LED (light-emitting diode) element typically involves use of a MOCVD (metal organic chemical vapor deposition) device. A MOCVD device, which is high in productivity and easy to maintain, is suitable for industrial mass production of such elements.

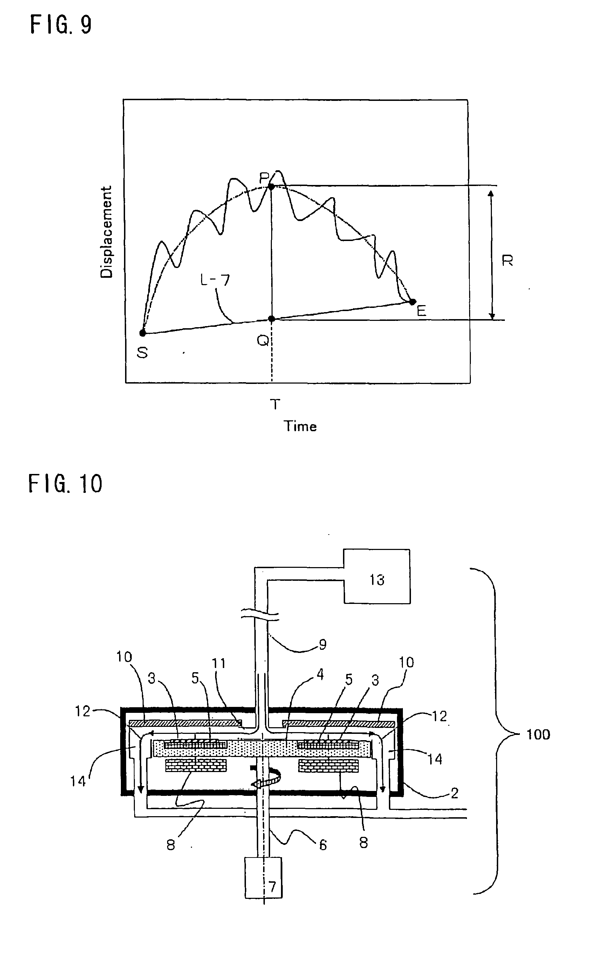

Fig. 10 illustrates an example MOCVD device. The MOCVD device 100 includes a reaction chamber 2, in which a plurality (six in this example) of substrates 3 are placed on respective placement plates 5 provided to an upper surface of a rotating table 4.

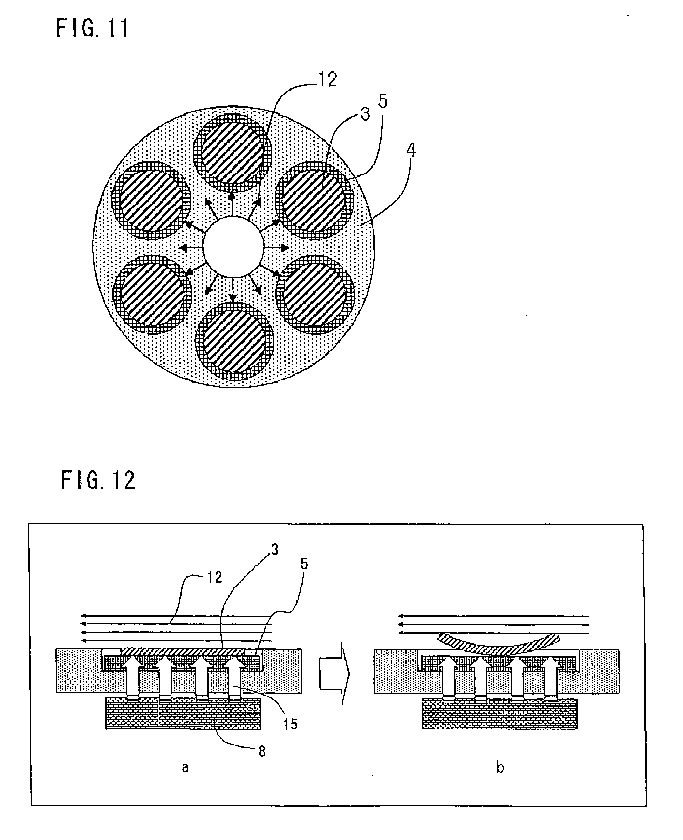

Fig. 11 is a plan view illustrating a relation between a holder of the MOCVD device 100 and substrates. The rotating table 4 is supported by an upper end of a rotating shaft 6, which is rotated by a motor 7. The placement plates 5 provided to the upper surface of the rotating table 4 are each arranged to rotate on its axis. Causing the substrates 3 to revolve and each rotate on its axis during crystal growth with use of the above arrangement can improve uniformity of a film to be grown.

The MOCVD device 100 includes a heater 8 provided below the rotating table 4 to heat the substrates 3. The MOCVD device further includes, above the rotating table 4, a partition wall 10 so provided substantially horizontally (in parallel) as to partition the space inside the reaction chamber 2. The reaction chamber 2 has an upper portion connected to a pipe 9, which has a first end that is positioned between the rotating table 4 and the partition wall 10 to act as a gas nozzle 11. This arrangement allows a material gas 12 as a material for a crystalline film to be fed, from a position on the rotation axis of the rotating table 4, radially over the surface of the rotating table 4. The pipe 9 has a second end connected to a gas feeder 13. The material gas 12 passes through a space directly above the substrates 3, which are placed on the respective placement plates 5 and heated by the heater 8, and is then exhausted through an exhaust path 14 provided at the periphery of the rotating table 4. This arrangement allows a desired chemical reaction to occur in the vicinity of a space directly above the substrates 3, and consequently allows a desired crystal growth to take place on the substrates 3.

When a substrate 3 is heated or a crystalline film is grown on the surface of the substrate 3, it may be warped depending on various conditions. Such a substrate 3 is likely warped especially in the case of growing a film of a group-III nitride represented primarily by a GaN-based compound semiconductor. Fig. 12 is a diagram illustrating a mechanism by which a substrate 3 is warped in the MOCVD device 100 during crystal growth. Specifically, the following is known: The heater 8 releases thermal energy 15, which is conducted, as illustrated in "a" of Fig. 12, to a substrate 3. This causes a temperature difference between (i) the surface of the substrate 3 which surface faces the heater 8 and (ii) the surface of the substrate 3 which surface is in contact with the material gas 12. This temperature difference in turn warps the substrate 3 as illustrated in "b" of Fig. 12 (see Patent Literature 1). Reducing such a warp in a substrate 3 has thus been an important issue. This leads to the necessity to immediately learn the state of a substrate 3 during film growth.

A commonly known method for measuring a warp in a substrate 3 is a trigonometrical survey involving a laser displacement meter. However, if a trigonometrical survey involving a laser displacement meter were to be carried out inside a film formation device such as the MOCVD device 100 illustrated in Fig. 10, radiation due to the substrate temperature would make it difficult to separate laser light from radiant light. This may prevent measurement of a warp in a substrate 3. Further, a trigonometrical survey involving a laser beam uses different paths for the emission and return of the laser beam. This would require the reaction chamber 2 to include a large window for allowing the laser beam to travel along both paths. In addition, the MOCVD device 100, if it includes a partition wall 10, would need to include, in the partition wall 10, a large hole for allowing the laser beam to travel along both paths for the emission and return of the laser beam. This would disturb the flow of the material gas 15. It has thus been impossible to carry out a trigonometrical survey in a MOCVD device 100.

Another effective means to measure a warp caused in a substrate during crystal growth is a method involving a laser Doppler velocimeter. This velocimeter calculates the amount of displacement by (i) emitting a laser beam onto a substrate, (ii) measuring the velocity of the substrate with use of the Doppler effect, and (iii) integrating the velocity. This method is advantage in that (i) the reaction chamber 2 simply needs to include a small window because a laser beam for use in measurement has substantially identical paths for its emission and return, and (ii) radiation due to the substrate temperature less likely affects the measurement because the measurement object is not a light intensity but a frequency shift.

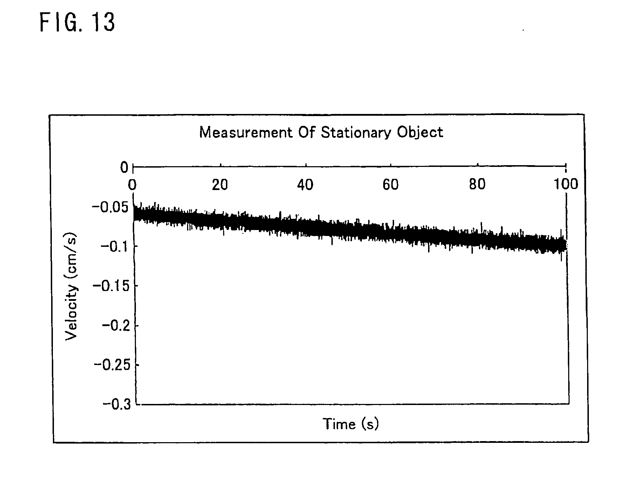

The method involving a laser Doppler velocimeter is, however, disadvantageous in that its laser output and a laser light receiving section, for example, are changed by such factors as an operating environment and time elapse. Thus, the velocity is not 0 even if a stationary measurement object is measured. Fig. 13 is a graph obtained by measuring a stationary object with use of a laser Doppler velocimeter for 100 seconds, the graph indicating the velocity along its ordinate. Fig. 13 indicates an offset value changing over time.

Velocity integration of an offset value other than 0 as above erroneously adds the offset value to a measurement result, which may make it impossible to measure a warp in a substrate. There is normally a high pass filter set so that the offset value is 0. However, in the case where the measurement object is extremely low in, for example, moving velocity and operating frequency, setting a high pass filter unfortunately removes even a velocity to be measured. While the MOCVD device 100 causes substrates 3 to revolve in order to prevent temperature variation, this revolution is normally low in velocity, and further, a warp change (warp amount) in a substrate ranges from several μm to several tens of μm, which has made it difficult to set a high pass filter.

Patent Literature 2 discloses a method for improving accuracy of measurement of a measurement object. This method assumes constancy in velocity change that is due to mispositioning of, for example, the rotation axis and optical axis of a rotating body which mispositioning is caused when the rotating body rotates once. The above method thus determines true displacement of a measurement object by subtracting (i) the displacement amount monotonically increased due to such mispositioning of, for example, the rotation axis and optical axis from (ii) the amount of displacement caused by one rotation at a certain measurement point. Inside a MOCVD device, however, a substrate has displacement that increases with time due to film deposition, that is, with an increase in the number of rotations. Further, a substrate has a warp that is different in, for example, the amount and direction of displacement depending on, for example, the film formation temperature and material. The above method thus does not yield 0 for the integrated value of true displacement for the case in which a substrate is rotated once. The technique disclosed in Patent Literature 2 assumes 0 for the integrated value of displacement for the case in which a substrate is rotated once, and on the basis of this assumption, determines that the value obtained by subtracting, from displacement at a certain point in time, displacement observed one rotation cycle before indicates an apparent displacement caused by, for example, mispositioning of the rotation axis and scattered light. Thus, even if the method of Patent Literature 2 is used to measure a warp in a substrate inside a MOCVD device, it may be impossible to separate out only a velocity change caused by an actual warp in a substrate, thus raising the risk of a decrease in accuracy. Further, if the amount of displacement due to, for example, a tilt and vibration of the mobile platform is larger than that of displacement caused by a warp in a substrate, that is, a measurement object, measurements have been made of such a tilt of the mobile platform instead, thus making it impossible to measure a warp in a substrate.

Citation list

Patent Literature 1
Japanese Patent Application Publication, Tokukai, No. 2005-72561 A (Publication Date: March 17, 2005)
Patent Literature 2
Japanese Patent Application Publication, Tokukai, No. 2005-69916 A (Publication Date: March 17, 2005)

Summary of Invention

Technical Problem

The present invention intends to solve the following problem: When the shape is measured of a measurement object, such as a substrate, that is placed on a mobile platform inside a MOCVD device, accuracy of measurement is decreased (i) by the influence of an offset value that varies depending on the operating environment for a velocity measuring device, (ii) in the case where the MOCVD device is a device in which a plurality of measurement objects are placed on a rotating table, and (iii) due to, for example, vibration of a rotating table and a tilt of the rotation axis.

The present invention has been accomplished in view of the above problem. It is an object of the present invention to provide a shape measurement device and shape measurement method both high in accuracy of measurement.

Solution to Problem

In order to solve the above problem, a shape measurement device of the present invention includes: velocity measuring means utilizing a Doppler effect; measurement object detecting means for detecting a position of a measurement object; and arithmetic processing means for computing a shape of the measurement object, the arithmetic processing means including: measurement object velocity extracting means for calculating a velocity of the measurement object by arithmetically processing a signal outputted from the velocity measuring means and a signal outputted from the measurement object detecting means; velocity average calculating means for calculating a velocity mean value for the measurement object with use of at least one signal outputted by the measurement object velocity extracting means; subtracting means for subtracting the velocity mean value from the velocity calculated by the measurement object velocity extracting means; and integrating means for calculating a time integral of a velocity obtained by the subtracting means.

With the above feature, the shape measurement device of the present invention causes the measurement object detecting means to detect that a measurement object is located at the position of the velocity measuring means from which position the velocity measuring means emits a laser beam, and thus accurately detects the position of a measurement object and allows the measurement object velocity extracting means to calculate only the velocity of the measurement object inside the arithmetic processing means. The shape measurement device thus (i) calculates a velocity mean value from at least a part of data of the velocity of the measurement object, (ii) removes, from the data of the velocity of the measurement object, a component attributed to the velocity mean value, and then (iii) calculates a time integral of the velocity to calculate displacement. This arrangement prevents influence of, for example, a tilt in the measurement object and an offset value for the velocity measuring means, and consequently improves accuracy of measurement.

In order to solve the above problem, another shape measurement device of the present invention includes: velocity measuring means utilizing a Doppler effect; measurement object detecting means for detecting a position of a measurement object; and arithmetic processing means for computing a shape of the measurement object, the arithmetic processing means including: measurement object velocity extracting means for calculating a velocity of the measurement object by arithmetically process a signal outputted from the velocity measuring means and a signal outputted from the measurement object detecting means; differential computing means for calculating a time differential of data obtained by the measurement object velocity extracting means; and adding means for calculating a time integral twice of the data obtained from the differential computing means.

The above feature prevents influence of, for example, a tilt in the measurement object and an offset value for the velocity measuring means, and allows even the amount of displacement to be calculated immediately when velocity data is obtained. This makes it possible to obtain data of a highly accurate measurement in real time.

In order to solve the above problem, a shape measurement method of the present invention includes: a velocity measuring step utilizing of a Doppler effect; a measurement object detecting step for detecting a position of a measurement object; and an arithmetic processing step for computing a shape of the measurement object, the arithmetic processing step including: a measurement object velocity extracting step for calculating a velocity of the measurement object by arithmetically processing a signal outputted in the velocity measuring step and a signal outputted in the measurement object detecting step; a velocity average calculating step for calculating a velocity mean value for the measurement object with use of at least one signal outputted in the measurement object velocity extracting step; a subtracting step for subtracting the velocity mean value, which is an output in the velocity average calculating step, from the velocity calculated in the measurement object velocity extracting step; and an integrating step for calculating a time integral of a velocity obtained in the subtracting step.

With the above feature, the shape measurement method (i) calculates a velocity mean value from data of the velocity of a measurement object, (ii) removes, from the data of the velocity of the measurement object, a component attributed to the velocity mean value, and then (iii) integrates the velocity. This makes it possible to prevent influence of, for example, a tilt in the measurement object and an offset value for the velocity measuring step, and consequently improves accuracy of measurement.

Another shape measurement method of the present invention includes: a velocity measuring step utilizing of a Doppler effect; a measurement object detecting step for detecting a position of a measurement object; and an arithmetic processing step for computing a shape of the measurement object, the arithmetic processing step including: a measurement object velocity extracting step for extracting a velocity of the measurement object by arithmetically processing a signal outputted in the velocity measuring step and a signal outputted in the measurement object detecting step; a differential arithmetic processing step for calculating a time differential of data obtained in the measurement object velocity extracting step; and an adding step for calculating a time integral twice of the data obtained in the differential arithmetic processing step.

With the above feature, the arithmetic processing means calculates acceleration of a measurement object by differentiating velocity data obtained by a measurement object velocity extraction for extracting the velocity of a measurement object, and integrates the acceleration twice. This makes it possible to prevent influence of, for example, a tilt in the measurement object and an offset value for the velocity measuring step. The above feature further allows the amount of displacement to be calculated immediately when velocity data is obtained, and consequently makes it possible to obtain data of a highly accurate measurement in real time.

Advantageous Effects of Invention

A shape measurement device of the present invention causes the measurement object detecting means to detect that a measurement object is located at the position of the velocity measuring means from which position the velocity measuring means emits a laser beam, and thus accurately detects the position of a measurement object and allows the measurement object velocity extracting means to calculate only the velocity of the measurement object inside the arithmetic processing means. The shape measurement device thus (i) calculates a velocity mean value from at least a part of data of the velocity of the measurement object, (ii) removes, from the data of the velocity of the measurement object, a component attributed to the velocity mean value, and then (iii) calculates a time integral of the velocity to calculate displacement. This arrangement advantageously prevents influence of, for example, a tilt in a measurement object and an offset value for the velocity measuring means, and consequently improves accuracy of measurement.

Another shape measurement device of the present invention (i) calculates a velocity mean value from data of the velocity of a measurement object, (ii) removes, from the data of the velocity of the measurement object, a component attributed to the velocity mean value, and then (iii) integrates the velocity. This makes it possible to advantageously prevent influence of, for example, a tilt in the measurement object and an offset value for a velocity measurement, and consequently improves accuracy of measurement.

Additional objects, features, and strengths of the present invention will be made clear by the description below. Further, the advantages of the present invention will be evident from the following explanation in reference to the drawings.

Brief Description of Drawings

Fig. 1

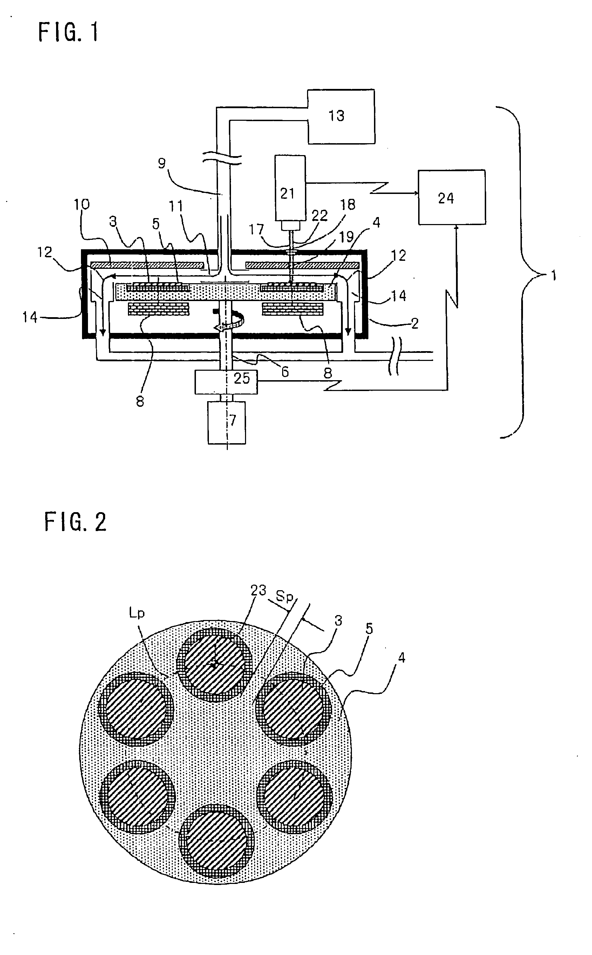

Fig. 1 is a conceptual diagram illustrating a MOCVD device (shape measurement device) of Embodiment 1.
Fig. 2
Fig. 2 is a plan view illustrating a relation between (i) placement plates (holders) included in the MOCVD device of Embodiment 1 and (ii) substrates.
Fig. 3

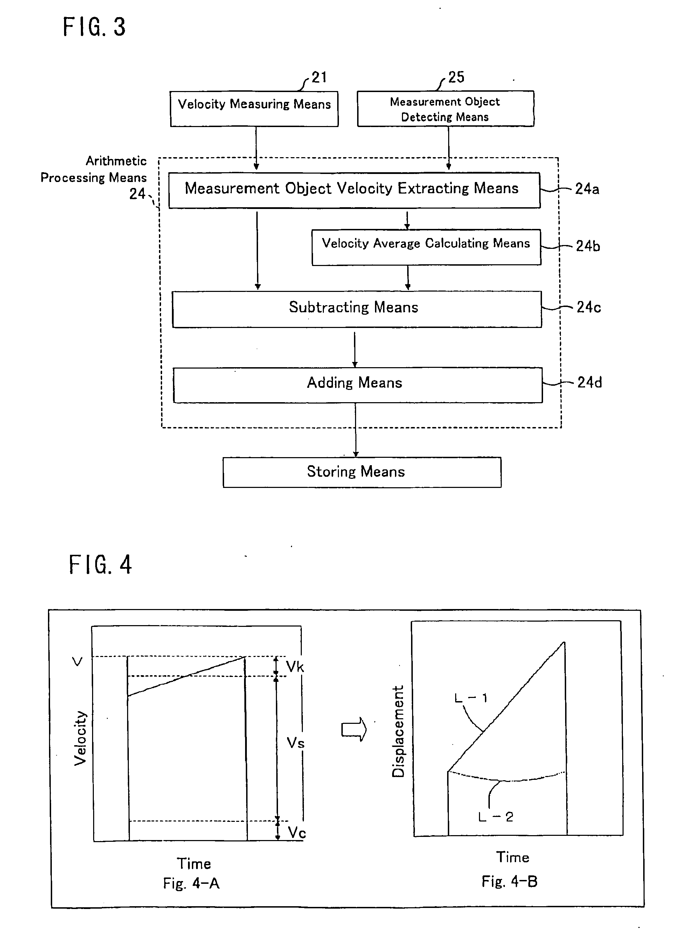

Fig. 3 is a diagram illustrating the flow of a data processing by the MOCVD device of Embodiment 1.
Fig. 4
Fig. 4 shows (i) a graph illustrating results of velocity measurement for a case involving a tilt and offset in the rotation axis of a rotating table (mobile platform) and (ii) a graph illustrating displacement obtained by integrating the velocities.
Fig. 5

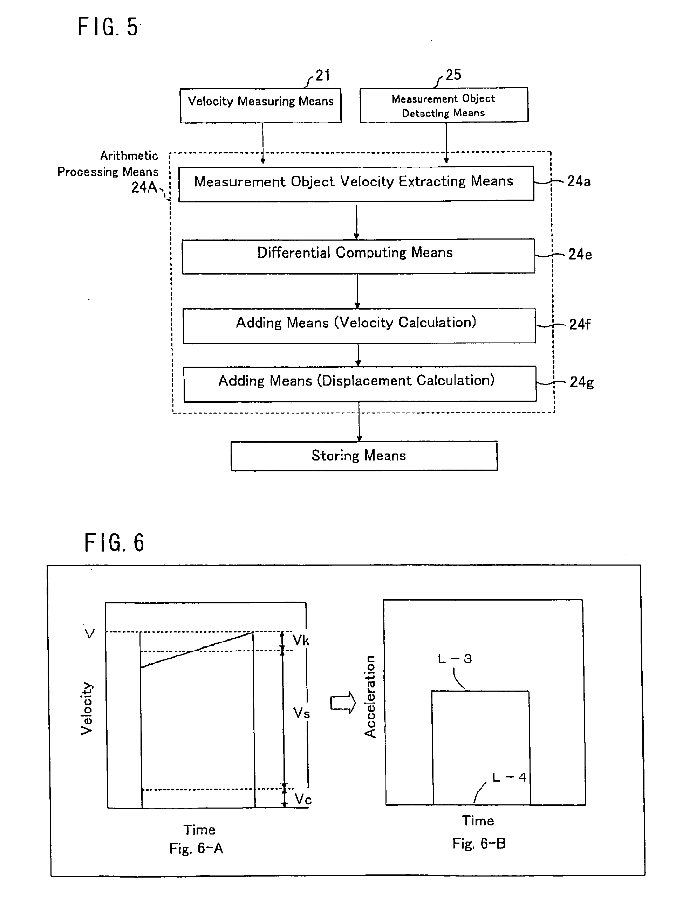

Fig. 5 is a diagram illustrating the flow of a data processing by a MOCVD device (shape measurement device) of Embodiment 2.
Fig. 6
Fig. 6 shows (i) a graph illustrating results of velocity measurement for a case involving a tilt and offset in the rotation axis of a rotating table (mobile platform) and (ii) a graph illustrating acceleration obtained by differentiating the velocities.
Fig. 7

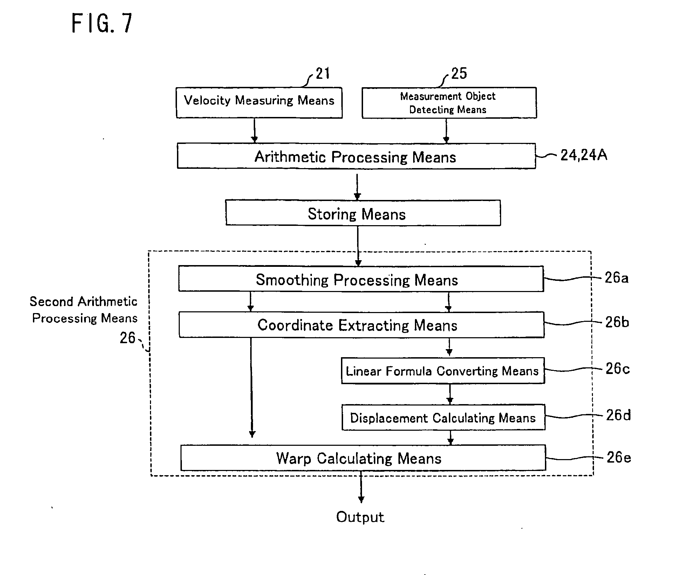

Fig. 7 is a diagram illustrating the flow of a data processing by a MOCVD device (shape measurement device) of Embodiment 3.
Fig. 8

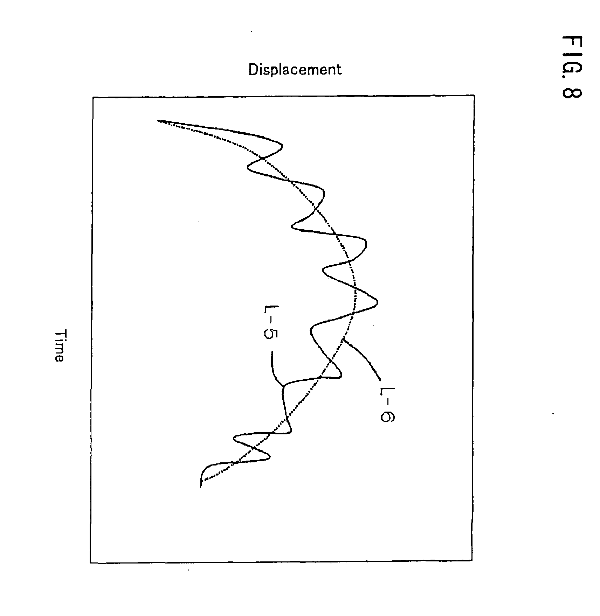

Fig. 8 is a graph illustrating (i) results of displacement measurement for a case involving vibration of a rotating table (mobile platform) and (ii) results of a smoothing processing.
Fig. 9
Fig. 9 is a graph illustrating how a warp amount is found from results of displacement measurement of a substrate in a case involving vibration for a rotating table (mobile platform).
Fig. 10
Fig. 10 is a conceptual diagram illustrating an example MOCVD device based on a conventional technique.
Fig. 11
Fig. 11 is a diagram illustrating a state in which substrates are placed on a rotating table in an example MOCVD device based on a conventional technique.
Fig. 12
Fig. 12 is a diagram illustrating a mechanism by which a substrate is warped during crystal growth in a MOCVD device based on a conventional technique.
Fig. 13
Fig. 13 illustrates an example of results of a velocity output of a laser Doppler velocimeter for a case involving measurement made of a stationary object without a high pass filter.

Description of Embodiments

(Embodiment 1)

With reference to Figs. 1 and 2, the description below deals with, as a shape measurement device of the present invention, Embodiment 1, in which the present invention is applied to a MOCVD device including (i) measurement object detecting means in which a rotation angle measuring instrument is incorporated and (ii) velocity measuring means which makes use of the principle of the Doppler effect of a laser beam. Fig. 1 is a conceptual diagram illustrating a configuration of a MOCVD device (shape measurement device) 1 of Embodiment 1. Fig. 2 is a plan view illustrating a relation between placement plates 5 (holders) of the MOCVD device 1 and substrates 3 (measurement objects).

The MOCVD device 1, as illustrated in Fig. 1, includes a cylindrical reaction chamber 2, which contains a rotating table 4. The rotating table 4 is provided with, on an upper portion thereof, a plurality of placement plates 5 that are each located at a particular radial position and that are separated from one another by a fixed pitch. The placement plates 5 each have an upper surface on which a substrate 3 as a process target substrate is to be placed. The MOCVD device may alternatively be arranged such that substrates 3 are not placed directly on the respective upper surfaces of the placement plates 5, and that substrates are instead each placed on a substrate holder made of, for example, quartz or boron nitride. The substrates 3 are each made of, for example, GaAs, InP, GaN, or sapphire. The MOCVD device further includes a heater 8 as heating means below the rotating table 4. The rotating table 4 has a lower portion connected to a rotating shaft 6, which has a lower end provided with a motor 7. In other words, the rotating table 4 is supported by the rotating shaft 6, which is connected to a central portion of a lower surface of the rotating table 4. With this arrangement, rotating the rotating shaft 6 with use of the motor 7 in turn rotates the rotating table 4. In other words, the rotating table 4 is rotated with the rotating shaft 6 as the center. Further, the placement plates 5 are arranged to each rotate on its axis. This arrangement allows the rotating table 4 to rotate and the placement plates 5 to each rotate on its axis during crystal growth, which causes the substrates 3 to revolve and each rotate on its axis. This improves uniformity of a film (crystal growth film) to be grown.

The MOCVD device includes, above the motor 7, measurement object detecting means 25 in which a rotation angle measuring instrument is incorporated. The MOCVD device further includes, above the rotating table 4, a partition wall 10 through which gas does not easily penetrate, the partition wall being so provided substantially horizontally (in parallel) as to partition the space inside the reaction chamber 2. The reaction chamber 2 has an upper portion connected to a pipe 9, which has a first end that is positioned between the rotating table 4 and the partition wall 10 to act as a gas nozzle 11. This arrangement allows a material gas 12 as a material for a crystalline film to be fed, from a position on the rotation axis of the rotating table 4, radially over the surface of the rotating table 4. The pipe 9 has a second end connected to a gas feeder 13. The material gas 12 passes through a space directly above the substrates 3, which are placed on the respective placement plates 5 and heated by the heater 8, and is then exhausted through an exhaust path 14 provided at the periphery of the rotating table 4. This arrangement allows a desired chemical reaction to occur in the vicinity of a space directly above the substrates 3, and consequently allows a desired crystal growth to take place on the substrates 3.

The MOCVD device includes, fitted outside the reaction chamber 2, velocity measuring means 21 which makes use of the principle of the Doppler effect of a laser beam. The velocity measuring means 21 is positioned so that (i) a measurement laser beam 17 emitted by the velocity measuring means 21 reaches a substrate 3 inside the reaction chamber 2 and that (ii) return light 22 returns to the velocity measuring means 21. The reaction chamber 2 thus includes a window 18 that allows passage of the measurement laser beam 17 and the return light 22. The partition wall 10 similarly includes a hole 19 that allows passage of the measurement laser beam 17 and the return light 22.

Fig. 2 is a plan view illustrating the rotating table 4. As illustrated in Fig. 2, a plurality of substrates 3 are arranged on the rotating table 4 along a particular circumference in such a manner as to be separated from one another by a gap Sp that separates adjacent placement plates 5. When the rotating table 4, on which the substrates 3 are placed, is rotated, the center 23 of each substrate 3 follows a trajectory Lp. The velocity measuring means 21 is so positioned that the measurement laser beam 17 is incident on a point along the trajectory Lp.

With the above arrangement, when the rotating table 4 is rotated, the measurement laser beam 17 is incident on one substrate 3 after another along the trajectory Lp. The velocity measuring means 21 thus measures the velocity for a direction perpendicular to a surface of each substrate 3. Data obtained by this measurement is supplied to arithmetic processing means 24.

The following describes a data processing method with reference to Fig. 3. Fig. 3 is a diagram illustrating the flow of a data processing by the MOCVD device, that is, a diagram illustrating a processing carried out inside the arithmetic processing means 24. The measurement object detecting means 25, as a default, (i) sets the rotation angle for the rotation angle measuring instrument to 0 and (ii) stores information on the respective positions of the substrates 3 and on the position of the velocity measuring means 21 from which position the velocity measuring means 21 emits a laser beam. The measurement object detecting means thus supplies, to the arithmetic processing means 24, (i) information on the angle of rotation and on the respective positions of the substrates observed when the angle of rotation is 0, and on the basis of the position of the velocity measuring means 21 from which position the velocity measuring means 21 emits a laser beam, (ii) information that a substrate (measurement object) is located at the laser beam emitting position.

The arithmetic processing means 24 includes: measurement object velocity extracting means 24a; velocity average calculating means 24b; subtracting means 24c; and adding means 24d. After the velocity measuring means 21 and the measurement object detecting means 25 supply respective output values to the arithmetic processing means 24, the measurement object velocity extracting means 24a included in the arithmetic processing means 24 extracts the respective velocities of the substrates 3 from the output value of the measurement object detecting means 25, and transmits data of the velocities to the subtracting means 24c and the velocity average calculating means 24b. The velocity average calculating means 24b calculates a mean value of the velocity observed when a substrate 3 passes the laser beam emitting position. The subtracting means 24c subtracts the velocity mean value, calculated by the velocity average calculating means 24b, from each of the values of the respective velocities of the measurement objects (substrates 3), and supplies a result of the subtraction to the adding means 24d.

The following describes, with reference to Fig. 4, how subtracting a velocity mean value from each of the values of the respective velocities of the substrates 3 leads to extraction of only a velocity change caused by a substrate warp. Fig. 4 shows (i) a graph (graph A) illustrating results of velocity measurement for a case involving a tilt and an offset in the rotating sha.ft 6 supporting the rotating table 4 (mobile platform) and (ii) a graph (graph B) illustrating displacement obtained by integrating the velocities. The graph A of Fig. 4 illustrates how an output value of the velocity measuring means 21 changes over time when the velocity measuring means 21 measures the velocity of a substrate 3. Assuming that an upward direction perpendicular to the surface (film formation surface) of a substrate 3 is a positive direction, in a case where the substrate 3 is, for example, warped downward, the warp in the substrate 3 has a velocity that changes, as illustrated in Fig. 4, from the negative side through zero (corresponding to the bottom of the downward warp) to the positive side. The graph A of Fig. 4 indicates (i) the velocity output value along its ordinate and (ii) time along its abscissa. The velocity measuring means 21 outputs data that is illustrated in the graph A of Fig. 4 and that is represented by the equation below, where V is the output value; Vk is, in a case where the substrate 3 as a measurement object has, for example, a downward warp, a velocity change for the range from the bottom of the warp to an end of the substrate; Vo is an offset value of the velocity measuring means 21; and Vs is a velocity change caused by a tilt in the rotating shaft 6 supporting the rotating table 4.

$$V = Vk + Vo + Vs$$

As illustrated in Fig. 13, when a stationary object is measured with use of a laser Doppler velocimeter, the offset value changes with time. In this case, velocity integration of an offset value other than 0 erroneously adds the offset value to a measurement result. However, even if the offset value changes with time, the offset value can be regarded as unchanged and thus constant with respect to a relatively short period during which a single substrate 3 passes the position of incidence of a laser beam. Fig. 13 illustrates an example of a measurement made for 100 seconds. In the present embodiment, in contrast, a substrate 3 passes the laser beam incident position in approximately 0.6 second. Fig. 13 verifies that the offset value is constant with respect to a period of 0.6 second. Further, since the rotating table 4 is several times as large as a substrate 3, velocity attributed to a tilt in the rotating shaft 6 can be regarded as constant with respect to a relatively short period during which a substrate 3 passes the laser beam incident position. Directly integrating the velocity data V produces a result indicated by a graph line rising to the right, such as that indicated by L-1 in the graph B of Fig. 4. This is due to the following: Typically, displacement due to a warp in a substrate 3 is larger than displacement caused by, for example, a tilt in the rotating shaft 6. Thus, displacement L-2 obtained by integrating a velocity change attributed to a warp unfortunately disappears when combined with displacement obtained by integrating a velocity change attributed to, for example, a tilt in the rotating shaft 6. This produces a result such as that indicated by L-1, thus making it impossible to measure an actual warp in a substrate.
V, in contrast, has a mean value given by

$$Vave \approx Vo + Vs,$$

where Vave is the mean value. The velocity change can be calculated from the following equation:

$$Vk = V - Vave$$

The above sign "≈" means "nearly equal".
The above description indicates that it is possible, by (i) finding a mean value of the data V of the velocities achieved by a substrate 3 passing a laser beam emitting position and (ii) subtracting the mean value from each of the velocity values, to extract only a velocity change caused by a warp in a substrate 3.
The adding means 24d (i) calculates a time integral of the velocity, obtained by extracting, as described above, only a velocity component attributed to a warp in a substrate 3, and (ii) supplies information about the time integral to storing means. The shape of a substrate 3 can thus be determined by using, as position information, a time integral value stored in the storing means.
The above description involves a rotation angle measuring instrument as the measurement object detecting means 25. The present embodiment is, however, not limited to such an arrangement. The present embodiment may alternatively use another method such as (i) a method of providing a marker to a substrate 3 and measuring the marker and (ii) a method of capturing an image of a substrate 3.

(Embodiment 2)

The following description deals with Embodiment 2 with reference to Fig. 5. Fig. 5 is a diagram illustrating the flow of a data processing by a MOCVD device (shape measurement device) of Embodiment 2, that is, a diagram illustrating a processing carried out inside an arithmetic processing means 24A. The arithmetic processing means 24A of the Embodiment 2 includes: measurement object velocity extracting means 24a; differential computing means 24e; adding means (velocity calculation) 24f; and adding means (displacement calculation) 24g.
As in Embodiment 1, the velocity measuring means 21 and the measurement object detecting means 25 supply respective output values to the arithmetic processing means 24A. The measurement object velocity extracting means 24a included in the arithmetic processing means 24A extracts the respective velocities of the substrates 3 from the respective output values of the velocity measuring means 21 and the measurement object detecting means 25. The differential computing means 24e then differentiates data of the velocities, extracted by the measurement object velocity extracting means 24a, to calculate respective accelerations of the substrates 3. The differential computing means 24e supplies, to the adding means 24f, information on the above-obtained respective accelerations of the substrates 3. The adding means 24f then calculates a time integral of the supplied respective accelerations of the substrates 3 to calculate a velocity (substrate velocity), and supplies information on the calculated velocity to the adding means 24g. The adding means 24g calculates a time integral of the calculated substrate velocity to calculate displacement.

The following describes, with reference to Fig. 6, how differentiating data of velocities extracted by the measurement object velocity extracting means 24a can extract only a velocity change caused by a warp in a substrate 3. Fig. 6 shows (i) a graph (graph A) illustrating results of velocity measurement for a case involving a tilt and an offset in the rotating shaft 6 supporting the rotating table 4 (mobile platform) and (ii) a graph (graph B) illustrating acceleration obtained by differentiating the velocities. The graph A of Fig. 6 is identical to the graph A of Fig. 4. As described in relation to the graph A of Fig. 4, it is possible to assume constancy in the velocity attributed to, for example, an offset value and a tilt in the rotating shaft 6. Thus, differentiating the graph A of Fig. 6 results in, as indicated by L-4 in the graph B of Fig. 6, the value 0 for the acceleration attributed to the offset value and a tilt in the rotating shaft 6. In other words, as indicated by L-3 in the graph 6-B, there remains, as acceleration, only a change caused by a warp in a substrate 3, the warp having a velocity change. As a result, it is possible to extract only a velocity change caused by a warp in a substrate 3.

The adding means 24f (i) calculates a time integral of acceleration data obtained by, as described above, using the differential computing means 24e to extract a component attributed to a warp in a substrate 3, and (ii) converts the time integral into a velocity (substrate velocity). The adding means 24g then calculates a time integral of the substrate velocity, converts the time integral into displacement, and supplies information on the displacement to storing means. The shape of a substrate 3 can thus be determined by using, as position information, displacement information stored in the storing means as above.

(Embodiment 3)

The following description deals with Embodiment 3 with reference to Fig. 7 through 9. Fig. 7 is a diagram illustrating the flow of a data processing by a MOCVD device (shape measurement device) of Embodiment 3.

The MOCVD device of the present embodiment includes: arithmetic processing means 24 or 24A described in Embodiment 1 or 2; and second arithmetic processing means 26. The second arithmetic processing means 26 includes: smoothing processing means 26a; coordinate extracting means 26b; linear formula converting means 26c; displacement calculating means 26d; and warp calculating means 26e.

The MOCVD device of the present embodiment obtains displacement values with use of the arithmetic processing means 24 or 24A similar to that of Embodiment 1 or 2, and temporarily supplies the displacement values to storing means. The smoothing processing means 26a included in the second arithmetic processing means 26, on the basis of a relation between (i) displacement values temporarily stored in the storing means and (ii) time, converts the amount of displacement for a single substrate into data smoothed by the method of least square. Fig. 8 shows (i) a line (indicated by L-5) indicative of results (displacement values) of displacement measurement for a case involving vibration of the rotating table 4 (mobile platform) and (ii) a line (indicated by L-6) indicative of results of smoothing displacement values. In the case where, for example, data read from the storing means is represented by L-5 in Fig. 8, such deformation as indicated by L-5 in Fig. 8 is, assuming that the substrate surface (that is, the film formation surface of a substrate 3) is smooth, unthinkable. Thus, the present embodiment assumes the swing of L-5 as caused by vibration of the rotating table 4, and carries out a smoothing processing to convert the displacement values into data smoothed as indicated by L-6. The present embodiment, as described above, carries out a smoothing processing to remove, from data obtained by the velocity measuring means 21, a component attributed to vibration of the rotating table 4. The smoothed data is either stored in the storing means again or supplied to the coordinate extracting means 26b.

The coordinate extracting means 26b obtains smoothed data from either the storing means or the smoothing processing means 26a. The coordinate extracting means then extracts, from the smoothed data, data of (i) time and displacement for a substrate start point and a substrate end point and (ii) time at which the displacement data peaks and the peak value, and supplies the extracted data to the linear formula converting means 26c. The data of the peak value is supplied to the warp calculating means 26e as well. Fig. 9 is a graph illustrating how a warp amount is found from results of displacement measurement of a substrate 3 in a case involving vibration of the rotating table 4 (mobile platform). The coordinate extracting means 26b, as illustrated in Fig. 9, extracts coordinates of a start point S and end point E of a substrate measurement. The linear formula converting means 26c creates a linear formula L-7 from data of the coordinates of the start point S and end point E, the coordinates having been extracted by the coordinate extracting means 26b. The linear formula converting means then supplies information on the linear formula L-7 to the displacement calculating means 26d. The displacement calculating means 26d inputs, to the linear formula L-7, a time T at which the displacement has a peak value P, and calculates a displacement Q for the time T to supply a result of the calculation to the warp calculating means 26e. The warp calculating means 26e calculates the difference between the peak value P and the displacement Q, calculated by the displacement calculating means 26d, and thus outputs the difference as a warp amount R. The warp calculating means further determines, from whether the warp amount R is positive or negative, whether the warp in a substrate 3 is an upward warp or a downward warp, and thus stores a result of the determination in the storing means (not shown). In the case of, for example, Fig. 9, where P > Q in displacement, the warp calculating means determines that the warp is an upward warp.

As described above, the shape measurement device (MOCVD device) of the present invention may preferably include smoothing processing means 26a for smoothing displacement values. This feature makes it possible to advantageously remove a component attributed to vibration in the rotating table 4 (mobile platform).

The shape measurement device (MOCVD device) of the present invention may preferably include coordinate extracting means 26b for extracting (i) a time and displacement for a first position at which a measurement starts of the measurement object, (ii) a time and displacement for a second position at which the measurement ends, and (iii) a time and displacement for a peak value; linear formula converting means 26c for converting coordinates of (i) the time and displacement, extracted by the coordinate extracting means 26b, for the first position and (ii) the time and displacement, extracted by the coordinate extracting means 26b, for the second position into a linear formula involving time as a variable; displacement calculating means 26d for calculating, with use of the linear formula converting means 26c, a displacement observed at a time instant of the peak value; and warp calculating means 26e for calculating a warp from a difference between (i) the displacement calculated by the displacement calculating means 26d and (ii) the peak value.

The above feature allows the warp calculating means 26e to calculate a warp from the calculated displacement and the peak value, and consequently makes it possible to easily determine a warp amount.

A shape measurement device of the present invention may include: velocity measuring means utilizing a Doppler effect; measurement object detecting means for detecting a position of a measurement object; and arithmetic processing means, the arithmetic processing means including: measurement object velocity extracting means for calculating a velocity of the measurement object by arithmetically processing a signal outputted from the velocity measuring means and a signal outputted from the measurement object detecting means; velocity average calculating means for calculating a velocity mean value for the measurement object with use of a signal outputted by the measurement object velocity extracting means; subtracting means for subtracting the velocity mean value from the velocity calculated by the measurement object velocity extracting means; and integrating means for calculating a time integral of a velocity obtained by the subtracting means.

A shape measurement device of the present invention may include velocity measuring means utilizing a Doppler effect; measurement object detecting means for detecting a position of a measurement object; and arithmetic processing means, the arithmetic processing means including: measurement object velocity extracting means for calculating a velocity of the measurement object by arithmetically process a signal outputted from the velocity measuring means and a signal outputted from the measurement object detecting means; differential computing means for calculating a time differential of data obtained by the measurement object velocity extracting means; and adding means for calculating a time integral twice of the data obtained from the differential computing means.

The shape measurement device of the present invention may preferably include smoothing processing means for smoothing a displacement value.

The shape measurement device of the present invention may preferably include: coordinate extracting means for extracting (i) a time and displacement for a first position at which a measurement starts of the measurement object, (ii) a time and displacement for a second position at which the measurement ends, and (iii) a time and displacement for a peak value; linear formula converting means for converting coordinates of (i) the time and displacement, extracted by the coordinate extracting means, for the first position and (ii) the time and displacement, extracted by the coordinate extracting means, for the second position into a linear formula involving time as a variable; displacement calculating means for calculating, with use of the linear formula converting means, a displacement observed at a time instant of the peak value; and warp calculating means for calculating a warp from a difference between (i) the displacement calculated by the displacement calculating means and (ii) the peak value.

A shape measurement method of the present invention may include: a velocity measuring step utilizing of a Doppler effect; a measurement object detecting step for detecting a position of a measurement object; and an arithmetic processing step for measuring a shape of the measurement object, the arithmetic processing step including: a measurement object velocity extracting step for calculating a velocity of the measurement object by arithmetically processing a signal outputted in the velocity measuring step and a signal outputted in the measurement object detecting step; a velocity average calculating step for calculating a velocity mean value for the measurement object with use of at least one signal outputted in the measurement object velocity extracting step; a subtracting step for subtracting the velocity mean value, which is an output in the velocity average calculating step, from the velocity calculated in the measurement object velocity extracting step; and an integrating step for calculating a time integral of a velocity obtained in the subtracting step.

A shape measurement method of the present invention may include: a velocity measuring step utilizing of a Doppler effect; a measurement object detecting step for detecting a position of a measurement object; and an arithmetic processing step for measuring a shape of the measurement object, the arithmetic processing step including: a measurement object velocity extracting step for extracting a velocity of the measurement object by arithmetically processing a signal outputted in the velocity measuring step and a signal outputted in the measurement object detecting step; a differential arithmetic processing step for calculating a differential of data obtained in the measurement object velocity extracting step; and an integrating step for calculating a time integral twice of the data obtained in the differential arithmetic processing step.

As described above, when the shape is measured of a measurement object, such as a substrate, that is placed on a mobile platform inside a conventional MOCVD device, accuracy of measurement is decreased (i) by the influence of an offset value that varies depending on the operating environment for a velocity measuring device, (ii) in the case where the MOCVD device is a device in which a plurality of measurement objects are placed on a rotating table, and (iii) due to, for example, vibration of a rotating table and a tilt of the rotation axis. This has prevented an accurate measurement.

In contrast, a shape measurement device of the present invention measures the shape of a measurement object with use of: a mobile platform (rotating table 4) for moving a measurement object; velocity measuring means utilizing the Doppler effect of a laser beam; measurement object detecting means; arithmetic processing means; and storing means. The arithmetic processing means includes: measurement object velocity extracting means for extracting the velocity of the measurement object; velocity average calculating means for calculating a velocity mean value from velocity data; subtracting means for subtracting the velocity mean value from the velocity data; and adding means for integrating the velocity. The shape measurement device thus (i) calculates a velocity mean value from at least a part of data of the velocity of the measurement object, (ii) removes, from the data of the velocity of the measurement object, a component attributed to the velocity mean value, and then (iii) calculates a time integral of the velocity to calculate displacement. This arrangement prevents influence of, for example, a tilt in the measurement object and an offset value for the velocity measuring means, and consequently improves accuracy of measurement.
The present invention is not limited to the description of the embodiments above, but may be altered in various ways by a skilled person within the scope of the claims. Any embodiment based on a proper combination of technical means disclosed in different embodiments is also encompassed in the technical scope of the present invention.
The embodiments and concrete examples of implementation discussed in the detailed description of the invention serve solely to illustrate the technical details of the present invention, which should not be narrowly interpreted within the limits of such embodiments and concrete examples, but rather may be applied in many variations within the spirit of the present invention, provided that such variations do not exceed the scope of the patent claims set forth below.

Industrial Applicability

The present invention can specify the position of a reciprocating or rotating measurement object to measure, for example, the velocity and amount of displacement for the direction perpendicular to the moving direction of the measurement object. The present invention is thus applicable to measurement of (i) a measurement object present at a portion of a rotating housing, (ii) a measurement object moving in a single direction, or (iii) a measurement object present at a portion of a housing moving in a single direction or of a rotating housing, the measurement object itself rotating. The present invention is specifically applicable to measurement of, for example, (i) the height of a liquid surface of a sample in a stirring device for planetarily rotating a material and (ii) a film in an ion plating device.

Reference Signs List

| | |
|---|---|
| 1 | MOCVD device (shape measurement device) |
| 2 | reaction chamber |
| 3 | substrate (measurement object) |
| 4 | rotating table |
| 5 | placement plate |
| 6 | rotation axis |
| 7 | motor |
| 8 | heater |

# 19     EP 2 511 652 A1     20

| 9 | pipe |
|---|---|
| 10 | partition wall |
| 11 | gas nozzle |
| 12 | material gas |
| 13 | gas feeder |
| 14 | exhaust path |
| 15 | thermal energy |
| 17 | measurement laser beam |
| 18 | window |
| 19 | hole |
| 21 | velocity measuring means |
| 22 | return light |
| 23 | center |
| 24, 24A | arithmetic processing means |
| 24a | measurement object velocity extracting means |
| 24b | velocity average calculating means |
| 24c | subtracting means |
| 24d | adding means (integrating means) |
| 24e | differential computing means |
| 24f | adding means |
| 24g | adding means |
| 25 | measurement object detecting means |
| 26 | second arithmetic processing means |
| 26a | smoothing processing means |
| 26b | coordinate extracting means |
| 26c | linear formula converting means |
| 26d | displacement calculating means |
| 26e | warp calculating means |

**Claims**

1. A shape measurement device comprising:

   velocity measuring means utilizing a Doppler effect;
   measurement object detecting means for detecting a position of a measurement object; and
   arithmetic processing means for computing a shape of the measurement object,
   the arithmetic processing means including:

   measurement object velocity extracting means for calculating a velocity of the measurement object by arithmetically processing a signal outputted from the velocity measuring means and a signal outputted from the measurement object detecting means;
   velocity average calculating means for calculating a velocity mean value for the measurement object with use of at least one signal outputted by the measurement object velocity extracting means;
   subtracting means for subtracting the velocity mean value from the velocity calculated by the measurement object velocity extracting means; and
   integrating means for calculating a time integral of a velocity obtained by the subtracting means.

2. A shape measurement device comprising:

   velocity measuring means utilizing a Doppler effect;
   measurement object detecting means for detecting a position of a measurement object; and
   arithmetic processing means for computing a shape of the measurement object,
   the arithmetic processing means including:

   measurement object velocity extracting means for calculating a velocity of the measurement object by arithmetically process a signal outputted from the velocity measuring means and a signal outputted from the measurement object detecting means;
   differential computing means for calculating a time differential of data obtained by the measurement object velocity extracting means; and
   adding means for calculating a time integral twice of the data obtained from the differential computing means.

3. The shape measurement device according to claim 1 or 2, further comprising:

second arithmetic processing means including smoothing processing means for smoothing a value of displacement of the measurement object which value has been found by the arithmetic processing means.

4. The shape measurement device according to claim 3, wherein:

the second arithmetic processing means further includes:

coordinate extracting means for extracting (i) a time and displacement for a first position at which a measurement starts of the measurement object, (ii) a time and displacement for a second position at which the measurement ends, and (iii) a time and displacement for a peak value; linear formula converting means for converting coordinates of (i) the time and displacement, extracted by the coordinate extracting means, for the first position and (ii) the time and displacement, extracted by the coordinate extracting means, for the second position into a linear formula involving time as a variable; displacement calculating means for calculating, with use of the linear formula converting means, a displacement observed at a time instant of the peak value; and warp calculating means for calculating a warp from a difference between (i) the displacement calculated by the displacement calculating means and (ii) the peak value.

5. A shape measurement method comprising:

a velocity measuring step utilizing of a Doppler effect; a measurement object detecting step for detecting a position of a measurement object; and an arithmetic processing step for computing a shape of the measurement object, the arithmetic processing step including:

a measurement object velocity extracting step for calculating a velocity of the measurement object by arithmetically processing a signal outputted in the velocity measuring step and a signal outputted in the measurement object detecting step; a velocity average calculating step for calculating a velocity mean value for the measurement object with use of at least one signal outputted in the measurement object velocity extracting step;

a subtracting step for subtracting the velocity mean value, which is an output in the velocity average calculating step, from the velocity calculated in the measurement object velocity extracting step; and an integrating step for calculating a time integral of a velocity obtained in the subtracting step.

6. A shape measurement method comprising:

a velocity measuring step utilizing of a Doppler effect; a measurement object detecting step for detecting a position of a measurement object; and an arithmetic processing step for computing a shape of the measurement object, the arithmetic processing step including:

a measurement object velocity extracting step for extracting a velocity of the measurement object by arithmetically processing a signal outputted in the velocity measuring step and a signal outputted in the measurement object detecting step; a differential arithmetic processing step for calculating a time differential of data obtained in the measurement object velocity extracting step; and an adding step for calculating a time integral twice of the data obtained in the differential arithmetic processing step.

FIG. 1

FIG. 2

FIG. 3

```
        ┌─21                        ┌─25
┌──────────────────────┐   ┌──────────────────────┐
│Velocity Measuring Means│  │ Measurement Object   │
│                        │  │  Detecting Means     │
└──────────────────────┘   └──────────────────────┘
```

Arithmetic
Processing Means
24

┌─────────────────────────────────────────────────┐
│ Measurement Object Velocity Extracting Means      │── 24a
└─────────────────────────────────────────────────┘

┌──────────────────────────────────┐
│ Velocity Average Calculating Means │── 24b
└──────────────────────────────────┘

┌─────────────────────────────────────────────────┐
│                Subtracting Means                  │── 24c
└─────────────────────────────────────────────────┘

┌─────────────────────────────────────────────────┐
│                  Adding Means                     │── 24d
└─────────────────────────────────────────────────┘

┌─────────────────────────────────────────────────┐
│                 Storing Means                     │
└─────────────────────────────────────────────────┘

FIG. 4

Fig. 4-A

Fig. 4-B

14

FIG. 5

```
         ┌─────21                ┌─────25
   ┌──────────────────────┐  ┌──────────────────────┐
   │Velocity Measuring Means│  │  Measurement Object  │
   └──────────────────────┘  │   Detecting Means    │
                              └──────────────────────┘
```

Arithmetic
Processing Means
24A

┌─────────────────────────────────────────────────┐
│  Measurement Object Velocity Extracting Means    │ ∼ 24a
└─────────────────────────────────────────────────┘
                        ↓
┌─────────────────────────────────────────────────┐
│           Differential Computing Means           │ ∼ 24e
└─────────────────────────────────────────────────┘
                        ↓
┌─────────────────────────────────────────────────┐
│        Adding Means (Velocity Calculation)       │ ∼ 24f
└─────────────────────────────────────────────────┘
                        ↓
┌─────────────────────────────────────────────────┐
│     Adding Means (Displacement Calculation)      │ ∼ 24g
└─────────────────────────────────────────────────┘
                        ↓
┌─────────────────────────────────────────────────┐
│                  Storing Means                   │
└─────────────────────────────────────────────────┘

FIG. 6

Velocity

V ┄┄┄┄┄┄┄┄┄┄┄┄┄┄┄┄ Vk
                   Vs
┄┄┄┄┄┄┄┄┄┄┄┄┄┄┄┄ Vc

Time
Fig. 6-A

⇒

Acceleration

L − 3
L − 4

Time
Fig. 6-B

# FIG. 7

```
         ╭21                        ╭25
 ┌──────────────────────┐  ┌──────────────────────┐
 │Velocity Measuring Means│  │ Measurement Object   │
 └──────────────────────┘  │   Detecting Means    │
                           └──────────────────────┘
            │                         │
            ▼                         ▼
 ┌───────────────────────────────────────────────┐
 │          Arithmetic Processing Means           │ ── 24,24A
 └───────────────────────────────────────────────┘
                         │
                         ▼
         ┌───────────────────────────────┐
         │         Storing Means          │
         └───────────────────────────────┘
                         │
```

Second Arithmetic
Processing Means

26

```
 ┌───────────────────────────────────────────────┐
 │          Smoothing Processing Means            │ ── 26a
 └───────────────────────────────────────────────┘
     │                          │
     ▼                          ▼
 ┌───────────────────────────────────────────────┐
 │          Coordinate Extracting Means           │ ── 26b
 └───────────────────────────────────────────────┘
     │                          │
     │              ┌──────────────────────────┐
     │              │ Linear Formula Converting Means │ ── 26c
     │              └──────────────────────────┘
     │                          │
     │              ┌──────────────────────────┐
     │              │ Displacement Calculating Means  │ ── 26d
     │              └──────────────────────────┘
     │                          │
     ▼                          ▼
 ┌───────────────────────────────────────────────┐
 │            Warp Calculating Means              │ ── 26e
 └───────────────────────────────────────────────┘
                         │
                         ▼
                      Output
```

FIG. 8

FIG. 9

FIG. 10

FIG. 11

FIG. 12

a                                    b

FIG. 13

Measurement Of Stationary Object

<div align="center">

**INTERNATIONAL SEARCH REPORT**

</div>

| International application No. |
| --- |
| PCT/JP2010/071734 |

**A. CLASSIFICATION OF SUBJECT MATTER**
*G01B11/24*(2006.01)i, *H01L21/66*(2006.01)i

According to International Patent Classification (IPC) or to both national classification and IPC

**B. FIELDS SEARCHED**

Minimum documentation searched (classification system followed by classification symbols)
G01B11/00-11/30, G01B21/00-21/32, H01L21/66

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2001-330431 A (Sony Corp.),<br>30 November 2001 (30.11.2001),<br>paragraphs [0005] to [0007], [0029] to [0068];<br>fig. 1 to 6<br>& US 2002/0034151 A1<br>paragraphs [0014] to [0021], [0056] to [0123];<br>fig. 1 to 6<br>& EP 1162610 A2<br>paragraphs [0012] to [0019], [0044] to [0111];<br>fig. 1 to 6 | 1-6 |
| Y | JP 10-253360 A (Murata Mfg. Co., Ltd.),<br>25 September 1998 (25.09.1998),<br>paragraphs [0017] to [0028]; fig. 1 to 7<br>(Family: none) | 1,3-5 |

☒ Further documents are listed in the continuation of Box C.    ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 05 January, 2011 (05.01.11) | 18 January, 2011 (18.01.11) |

| Name and mailing address of the ISA/<br>    Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2010/071734

C (Continuation). DOCUMENTS CONSIDERED TO BE RELEVANT

| Category* | Citation of document, with indication, where appropriate, of the relevant passages | Relevant to claim No. |
|---|---|---|
| Y | JP 6-34338 A (Mitsubishi Electric Corp.), 08 February 1994 (08.02.1994), paragraphs [0023] to [0028]; fig. 2 to 3 (Family: none) | 2,6 |
| Y | JP 2006-234540 A (JFE Steel Corp.), 07 September 2006 (07.09.2006), paragraphs [0018] to [0040]; fig. 2 to 5 (Family: none) | 3-4 |
| A | JP 1-267403 A (Sanyo Electric Co., Ltd.), 25 October 1989 (25.10.1989), entire text; all drawings (Family: none) | 1-2,5-6 |
| A | JP 63-191016 A (NEC Corp.), 08 August 1988 (08.08.1988), entire text; all drawings (Family: none) | 1-2,5-6 |
| A | JP 4-204008 A (NKK Corp.), 24 July 1992 (24.07.1992), entire text; all drawings (Family: none) | 3-4 |

Form PCT/ISA/210 (continuation of second sheet) (July 2009)

EP 2 511 652 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005072561 A

- JP 2005069916 A